Europäisches Patentamt

European Patent Office

Office européen des brevets

(19)

(11) Publication number: **0 039 223**
**B1**

# EUROPEAN PATENT SPECIFICATION

(12)

(45) Date of publication of patent specification: **07.08.85**

(51) Int. Cl.⁴: **G 03 G 5/082, G 03 G 5/14**

(21) Application number: **81301831.4**

(22) Date of filing: **24.04.81**

(54) **Electrophotographic member and method of operating an electrophotographic member.**

(30) Priority: **25.04.80 JP 54150/80**

(43) Date of publication of application:
**04.11.81 Bulletin 81/44**

(45) Publication of the grant of the patent:
**07.08.85 Bulletin 85/32**

(84) Designated Contracting States:
**DE FR GB NL**

(56) References cited:
**EP-A-0 001 549**
**EP-A-0 038 221**
**FR-A-2 412 874**
**GB-A-2 018 446**
**GB-A-2 024 186**

**IBM TECHNICAL DISCLOSURE BULLETIN, vol.**
**19, no. 12, May 1977, New York, US M.H.**
**BRODSKY et al. "Doping of sputtered**
**amorphous semiconductors" page 4802**

(73) Proprietor: **Hitachi, Ltd.**
**5-1, Marunouchi 1-chome**
**Chiyoda-ku Tokyo 100 (JP)**

(72) Inventor: **Ishioka, Sachio**
**1-46-23 Zoushigaya**
**Toshima-ku, Tokyo (JP)**
Inventor: **Maruyama, Eiichi**
**1572-3 Josuihoncho**
**Kodaira-shi, Tokyo (JP)**
Inventor: **Imarura, Yoshinori**
**2-32-C207 Koyasu-cho**
**Hachioji-shi Tokyo (JP)**
Inventor: **Matsubara, Hirokazu**
**3-10-1-A107 Shinmeidai Hamuramachi**
**Nishitama-gun, Tokyo (JP)**
Inventor: **Horigome, Shinkichi**
**7-52-13 Sunagawa-cho**
**Tachikawa-shi Tokyo (JP)**

(74) Representative: **Paget, Hugh Charles Edward**
**et al**
**MEWBURN ELLIS & CO. 2/3 Cursitor Street**
**London EC4A 1BQ (GB)**

Courier Press, Leamington Spa, England.

**Description**

This invention relates to an electrophotographic member for use for example as an electrophotographic plate, and particularly to an electrophotographic member which employs amorphous silicon as a photoconductive layer. The invention also relates to a method of operating an electrophotographic member.

Photoconductive materials used in electrophotographic members have included inorganic substances such as Se, CdS and ZnO and organic substances such as polyvinyl carbazole (PVK) and trinitrofluorenone (TNF). Although these have high photoconductivities, they have the disadvantage that the layers of them have insufficient hardness, so that their surfaces are flawed or wear away during operation as electrophotographic members. In addition, many of these materials are harmful to the human body, so that it is undesirable that the layers wear away to adhere on copying paper even in small amounts. In order to avoid these disadvantages, it has been proposed to employ amorphous silicon for the photoconductive layer (see, for example, Japanese Laid-open Patent Application No. 54—78135). In general, however, an amorphous silicon layer exhibits a dark resistivity which is too low for use as an electrophotographic member. An amorphous silicon layer having a high resistivity of the order of $10^{10}\Omega$.cm. has a photoelectric gain which is too low, and only layers unsatisfactory as electrophotographic members have so far been obtained.

It has been proposed, in GB—A—2018446, to provide an image-forming member for electrophotography in which hydrogen-containing amorphous silicon is laminated to an organic compound layer. This structure is proposed to solve the problem of low photoconductive gain for amorphous silicon having a high dark resistivity.

It has been proposed in GB—A—2024186 to provide an amorphous photoconductive material for use in a light sensitive film. The material contains silicon, carbon and hydrogen, and has a resistivity of about $10^{10}\Omega$.cm. Photosensitive example layers are disclosed having band gaps of from 1.66 eV to 2.20 eV.

In neither case is the depth to which incident light penetrates the amorphous silicon layer considered.

The present invention seeks to avoid the tendency to poor resolution, seeks to provide a low residual potential.

Accordingly, the invention provides a method of operating an electrophotographic member having a support and a photoconductive layer of amorphous silicon containing hydrogen and at least 50 atomic % silicon carried by said support the photoconductive layer including a surface region which is at least 10 nm thick and extends inwardly from a surface of the photoconductive layer, the surface region having an optical forbidden band gap of at least 1.6 eV and a resistivity of at least $10^{10}\Omega$.cm, characterized in that: the incident light is selected so that the distance between (a) the region at which the intensity of light illuminating said photoconductive layer on the light incident side thereof is reduced by absorption therein to 1% of the intensity at incidence and (b) the surface of said photoconductive layer opposite to said light incidence side thereof is not more than 5 μm.

Further, the invention provides an electrophotographic member having a support and a photoconductive layer of amorphous silicon containing hydrogen and on average at least 50 atomic % silicon, the support carrying the layer includes a first surface region which is at least 10 nm thick and extends inwardly from a first surface of the photoconductive layer, the first surface region having an optical forbidden band gap of at least 1.6 eV and a resistivity of at least $10^{10}\Omega$.cm, and in that the thickness of said photoconductive layer is such that the intensity of light of wavelength $\lambda_2$ (nm) illuminating the photoconductive layer on its light incident side is reduced by absorption to 1% of the intensity of incidence at a distance of not more than 5 μm from the surface of the photoconductive layer opposed to its light incident side, which surface is contacting an electrically conducting layer, $\lambda_2$ being given by

$$\lambda_2 \leq \lambda_1 - 100 \text{ nm}$$

wherein

$$\lambda_1 = \frac{1240}{E_{opt}} \cdot$$

in which $E_{opt}$ is the optical forbidden band gap (eV) of the layer.

By forming a region of the narrower optical forbidden band gap within the photoconductive layer, as described in more detail below, the sensitivity of the photoconductive layer to light of longer wavelengths can be enhanced.

Regarding the improvement of extending the sensitivity of the electrophotographic member to longer wavelengths, see European patent application No. 81.301671.4 *inter alia.*

In this specification (including the claims) we use the term "an amorphous silicon" to include amorphous silicon containing amounts of other elements, such as C, Ge and B, as described in more detail below.

Embodiments of the invention will now be described by way of example with reference to the accompanying drawings, in which:—

Figure 1 is a graph showing the relationship between the residual potential characteristics of an amorphous-silicon photoconductive layer and the wavelength of the illuminating light,

Figure 2 is a graph explaining the circumstances in which the incident light is absorbed within the amorphous-silicon photoconductive layer,

Figure 3 is a diagram showing the state densities of crystalline silicon and amorphous silicon,

Figure 4 is a diagram explaining the circumstances in which incident light is absorbed within an amorphous-silicon photoconductive layer of a structure having a region of a narrower optical forbidden gap within the layer,

Figures 5, 8 and 9 are sectional views each showing essential portions of an electrophotographic member which has an amorphous silicon photoconductive layer,

Figure 6 is a view explaining a reactive sputtering equipment which is used for producing amorphous silicon,

Figure 7 is a view showing the construction of a laser beam printer, and

Figure 10 is a view showing the construction of an electrophotographic drum.

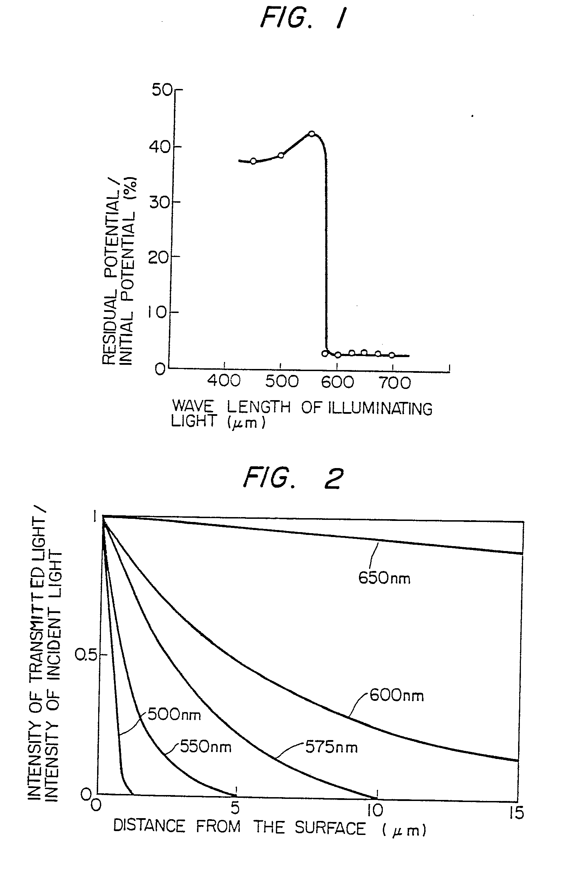

The inventors produced an electrophotographic member by the use of an amorphous silicon layer having a resistivity of at least $10^{10}\Omega$.cm over the entire layer, and investigated the residual potential characteristics thereof in detail. The result is shown in Figure 1, which shows that the magnitude of the residual potential depends greatly upon the wavelength of illuminating light. That is, the residual potential is conspicuously high where the wavelength of the incident light is shorter than a certain value, and it is extremely small where the wavelength is longer than this value. This tendency is especially noticeable where the thickness of the sample exceeds 5 µm.

As to the reason for this phenomenon, the inventors conjecture as follows. Amorphous silicon containing hydrogen differs in the amount of hydrogen contained in it and the form of the coupling between hydrogen and silicon, depending upon the conditions of formation of the layer, and has a peculiar optical forbidden band gap accordingly. Therefore, light of energy lower than energy corresponding to the optical forbidden band gap is transmitted through the layer without generating carriers by photoexcitation. For the amorphous silicon layer used in the measurements of Figure 1, results obtained by measuring the absorption of light of each wavelength within the layer are shown in Figure 2.

It is to be understood from Figure 2, that, at shorter wavelengths of the light, the light is absorbed in closer vicinity to the surface. Of the carriers generated by the absorbed light, those of sign opposite to that of charges stored on the surface of the photoconductive layer flow towards the surface to neutralize the charges, whereas those of the same sign must migrate to an electrode underlying the layer. Since the amorphous silicon layer in which the carriers migrate contains hydrogen, localized states within the layer have been considerably extinguished, but carrier trap levels still exist in the amorphous silicon more than in crystalline silicon, so that the capacity of the layer to allow migration is inferior. When in consequence, the generated photocarriers remain without being sufficiently drawn out, they cause an increase of the residual potential.

Referring again to Figure 1, the residual potential is extremely low where the wavelength of the light is longer than a certain value. Figure 2 reveals that the wavelength of the boundary between the high and low residual potentials corresponds to the energy at which the light passes through the whole photoconductive layer to reach the underlying substrate.

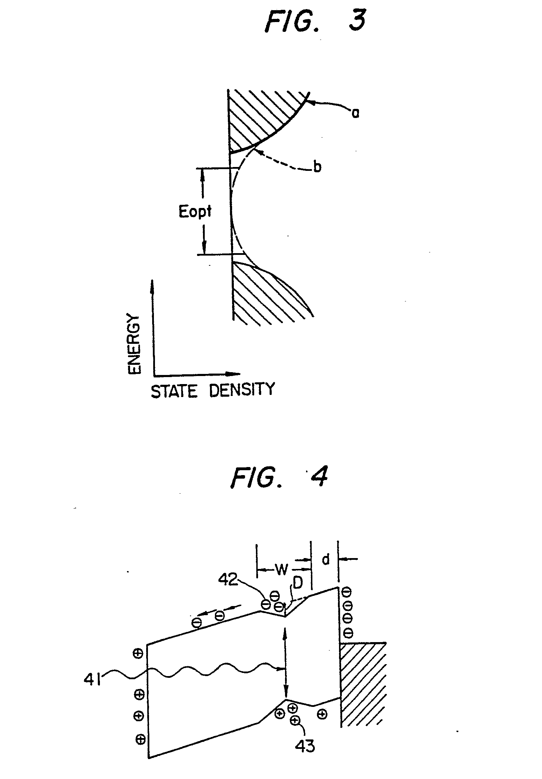

In the energy band structure, as shown by curve (b) in Figure 3, amorphous silicon containing hydrogen has a state density spreading inside the optical forbidden band gap ($E_{opt}$), in contrast to the case of crystalline silicon (illustrated by curve (a) in Figure 3). This state density distribution forms one cause for the trap levels mentioned above. However, when this material is illuminated by longer wavelength light, i.e. light of energy somewhat lower than the optical forbidden band gap, it is cleared by the illuminating light, and the capacity to allow carriers to migrate increases.

It is thought that the foregoing is the basis on which the wavelength-dependency shown in Figure 1 appears, and that the photo-carriers flowing towards the surface can reach the surface owing to the good migration capacity, whereas those flowing towards the underlying substrate side migrate through part of inferior migration capacity not illuminated by the light, so that they form a residual potential component without reaching the substrate. Therefore, when the layer is thicker than a certain amount and the migration region on the underlying substrate side is long, the residual potential increases.

As to the allowable limit of residual potential, since a present-day toner adheres to a photoconductive layer at approximately 600 V and separates away therefrom at or below 200 V, it is considered that a value of at most approximately 40% for this limit is desirable and that a value of at most 20% is much preferred. To achieve this value, it appears necessary to make the distance from the region at which at least 99% of the illuminating light is absorbed, to the underlying substrate at most 5 µm, more desirably at most 2 µm.

An actual electrophotographic member sometimes needs to have a thickness of 10—20 µm or above in order to withstand a voltage sufficient to hold the toner, so that the light absorbing part must reach substantially towards the substrate side.

One possible way of achieving this is to limit the wavelength of the illuminating light. The wavelength corresponding to the optical forbidden band gap $E_{opt}$ is:

**0 039 223**

$$\lambda_1 \text{ (nm)} = \frac{1{,}240}{E_{opt} \text{ (eV)}} \tag{1}$$

Letting $\lambda_2$ denote the wavelength of the light which, as stated previously is absorbed 99% before it reaches the distance of 5 μm from the underlying substrate side in the amorphous silicon layer used, the incident light may be confined within the following range:

$\lambda_2 \leq$ (wavelength of incident light) $\leq \lambda_1$ (2). The electrophotographic member then has its residual potential suppressed sufficiently while retaining a high photoconductivity.

Table 1 lists examples of the relationship between the hydrogen content and optical forbidden band gap ($E_{opt}$) of amorphous silicon. For hydrogen contents other than those specified, interpolation may satisfactorily be made.

TABLE 1

| Hydrogen content (at.−%) | $E_{opt}$ (eV) | $\lambda_1$ (nm) |
|---|---|---|
| 5 | 1.3 | 950 |
| 10 | 1.45 | 850 |
| 15 | 1.6 | 775 |
| 20 | 1.8 | 690 |
| 25 | 2.0 | 620 |

When using the photoconductive layer of this invention in a laser beam printer etc. the laser wavelength may be selected so as to fulfil the condition of Expression (2) above. According to the inventors' studies, $\lambda_2$ depends upon the thickness of the photoconductive layer. It is approximately 100—150 nm shorter than $\lambda_1$, and is experimentally determined.

In a system in which the photoconductive layer of this invention is illuminated by an ordinary white lamp or the like, it is satisfactory in practice to pass the light through a filter which cuts wavelengths shorter than $\lambda_2$ by an amount of at least 80%. For improvement of the residual potential, it is important that the illuminating light principally includes the component of wavelengths longer than $\lambda_2$. If the spectral width of the light is great, satisfactory sensitivity is achieved using the component fulfilling Expression (2). It is particularly important that, among the principal spectral components of the illuminating light, one on the longer wavelength side meets the condition mentioned above.

In addition it is possible to increase the sensitivity to light of longer wavelengths by forming a region of narrowed optical forbidden band gap within the photoconductive layer. This expedient will be described.

In a light receiving device of the storage mode such as an electrophotographic member, the resistivity of the photoconductive layer must satisfy the following two requirements:—

(1) it needs to be above approximately $10^{10}\Omega.\text{cm}$ lest charges stuck on the surface of the layer by corona discharge or the like should be discharged in the thickness direction of the layer before exposure,

(2) the sheet resistance of the photoconductive layer must be sufficiently high lest a charge pattern formed on the surface (as well as the interface) of the photoconductive layer upon exposure should disappear before development because of lateral flow of the charges. In terms of the resistivity, this should be above approximately $10^{10}\Omega.\text{cm}$ as in the preceding condition.

Amorphous silicon having such a resistivity is, in general, a material whose optical forbidden band gap is at least 1.6 eV.

In order to meet these two conditions, the resistivity at or near the surface of the photoconductive layer, which is to hold charges must be above approximately $10^{10}\Omega.\text{cm}$ but a resistivity of at least $10^{10}\Omega.\text{cm}$ need not exist uniformly through the thickness of the layer. If $\tau$ denotes the time constant of dark decay in the thickness direction of the layer, C the capacitance per unit area of the layer and R the resistance in the thickness direction per unit area of the layer, the following relation holds:

4

$$\tau = R.C \tag{3}$$

The time constant $\tau$ should be sufficiently long compared with the period of time from the exposure to development, and the resistance R should be sufficiently great in the thickness direction of the layer viewed macroscopically.

The inventors have revealed that, in determining the macroscopic resistance in the thickness direction of the layer in a high-resistivity thin-film device such as an electrophotographic member, charges injected from the interface with an electrode play an important role besides the resistivity of the layer itself.

The inventors have sought to solve this problem by employing amorphous silicon which has a resistivity of at least $10^{10}\Omega.cm$. Ordinarily, such a high-resistivity region is an intrinsic semiconductor (i-type). This region functions as a layer which blocks the injection of carriers from the electrode into the photoconductive layer, and can simultaneously be effectively used as a layer to hold the surface charges. In this case, the resistivity of that part of the photoconductive layer which does not adjoin the surface (or interface) need not always be as high as in the vicinity of the surface (or interface). That is, the macroscopic resistance R of the photoconductive layer may satisfy Expression (3). Therefore, sensitivity can be extended to the light of the longer wavelength region by a structure in which the optical forbidden band gap of the interior of the photoconductive layer is narrowed, so that the amorphous silicon layer can also be used as a photoconductive layer for a semiconductor laser beam printer.

In order more effectively to block the injection of carriers from the electrode, it is also effective to interpose a thin layer of $SiO_2$, $CeO_2$, $Sb_2S_3$, $Sb_2Se_3$, $As_2S_3$, $As_2Se_3$ or the like between the electrode and the amorphous silicon layer.

When the region of narrow forbidden band gap has been formed within the photoconductive layer in this manner, the longer wavelength light is absorbed in this region to generate electron-hole pairs. The situation is illustrated as an energy band model in Figure 4. Since, in both the region of wide forbidden band gap and the region of narrow forbidden band gap, the resistances of the portions themselves are desired to be as high as possible, the photoconductive layer should more preferably be fully intrinsic (i-type). The energy band model then has a shape constricted vertically with respect to the Fermi level. Photo-carriers generated in the constriction or the region of narrowed forbidden band gap are captured in the region by a built-in field existing therein. In order to draw the photo-carriers out of the region of narrowed forbidden band gap with an external electric field and to utilize them as effective photo-carriers, the external electric field must be greater than the built-in field of the region of narrowed forbidden band gap. Conversely stated, when forming the region of narrowed forbidden band gap, the built-in field arising therein must be smaller than the external electric field. The built-in field of the region of narrowed forbidden band gap depends upon the depth (potential difference) D and the width W of the region. An abrupt change of the band gap generates a large built-in field, whereas a gentle change of the band gap generates a small built-in field. When the shape of the region of narrowed forbidden band gap is approximated by an isosceles triangle, the condition for drawing out the photo-carriers is:

$$E_a \geq 2 \, D/W \tag{4}$$

where $E_a$ denotes the external electric field.

Within the amorphous-silicon photoconductive layer, the part in which the region of narrowed forbidden band gap exists should preferably be disposed in the portion of at most 5 μm from the interface (for example, the underlying substrate side) opposite to the light incidence side as stated before. In order to generate effective photo-carriers in the region of narrowed forbidden band gap, the width W of this region needs to be, in effect, at least 10 nm. The maximum limit of the width of the region of narrowed forbidden band gap is, of course, the whole thickness of the amorphous silicon layer, but the width W of the region is desired to be at most $\frac{1}{2}$ of the whole thickness of the layer in order to keep the total resistance R in the thickness direction sufficiently high.

The whole thickness of the amorphous-silicon photoconductive layer is determined by the surface potential, which in turn varies depending upon the kind of toner used and the service conditions of the photoconductive layer. However, the withstand voltage of the amorphous silicon layer is considered to be 10 V—50 V per μm. Accordingly, when the surface potential is 500 V, the entire layer thickness becomes 10 μm—50 μm. Values of the entire layer thickness exceeding 100 μm are not practical.

When applying the method of this invention to a photoconductive layer of such structure, with note taken of the fact that the absorption of light occurs principally in the region of narrowed optical forbidden band gap, the place in which this region exists should preferably be disposed in the vicinity of the underlying substrate side spaced therefrom only the distance $d$ of at most 5 μm. This situation is illustrated in Figure 4, which illustrates a case where positive charges are stored on the surface, and electrons 42 and holes 43 generated by incident light 41 flow so as to neutralize the charges.

Hereunder will be described an example of an electrophotographic member having an amorphous-silicon photoconductive layer.

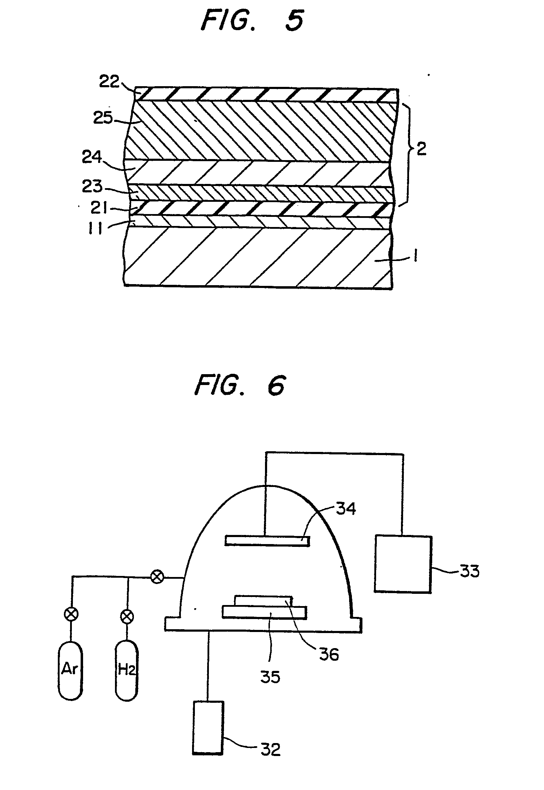

Referring to Figure 5, numeral 1 designates a substrate, and numeral 2 a photoconductive layer including an amorphous silicon layer. The substrate 1 may be any of a metal plate such as aluminum, stainless steel or nichrome plate, an organic material such as polyimide resin, glass ceramics etc. If the substrate is an electrical insulator, an electrode 11 needs to be deposited on the substrate. The electrode is a thin film of a metal material such as aluminum and chromium, or a transparent electrode of an oxide such as $SnO_2$ and In-Sn-O. The photoconductive layer 2 is disposed on the electrode. If the substrate 1 is light-transmissive and the electrode 11 is transparent, light to enter the photoconductive layer 2 is sometimes projected through the substrate 1. The photoconductive layer 2 can be provided with a layer 21 for suppressing the injection of excess carriers from the substrate side, and a layer 22 for suppressing the injection of charges from the surface side. As the layers 21 and 22, layers of a high-resistivity oxide, sulfide or selenide such as SiO, $SiO_2$, $Al_2O_3$, $CeO_2$, $V_2O_3$, $Ta_2O$, $As_2Se_3$ and $As_2S_3$ are used, or layers of an organic substance such as polyvinyl carbazole are sometimes used. Although these layers 21 and 22 serve to improve the electrophotographic characteristics of the photoconductive layer of this invention, they are not always absolutely indispensable. All layers 23, 24 and 25 are layers whose principal constituents are amorphous silicon. Each of the layers 23 and 25 is an amorphous silicon layer which satisfies the characteristics of this invention described above and has a thickness of at least 10 nm. Even when the resistivity of the layer 23 is below $10^{10}\Omega.cm$, no bad effect arises in the dark decay characteristics of the electrophotographic member owing to the presence of the layers 21 and 22. Although, in Figure 5, the amorphous silicon layer has a three-layered structure, it may of course be a uniform amorphous-silicon layer generally meeting the requirement of this invention.

It is sometimes the case that the amorphous silicon layer is doped with carbon or a very small amount of boron or with germanium in order to vary the electrical and optical characteristics of the layer. However, it is necessary for ensuring photoconductive characteristics that at least 50 atomic-% of silicon is contained on the average within the layer. As long as this requirement is fulfilled, layers fall within the scope of this invention whatever other elements they may contain.

As methods for forming an amorphous silicon layer containing hydrogen, the decomposition of $SiH_4$ by the glow discharge, the reactive sputtering process, the ion-plating process etc. are known. With any of the methods, a layer having the best photoelectric conversion characteristics is obtained when the substrate temperature during the formation of the layer is 150—250°C. In the glow discharge process, a layer of good photoelectric conversion characteristics has as low a resistivity as $10^6$—$10^7\Omega.cm$ and is unsuitable for electrophotography. Therefore, a measure such as doping the layer with a slight amount of boron to raise its resistivity is necessary. In contrast, the reactive sputtering process can produce a layer having a resistivity of at least $10^{10}\Omega.cm$ besides good photoelectric conversion characteristics, and moreover, it can form a uniform layer of large area by employing a sputtering target of sufficiently large area. It can therefore be said to be particularly useful for forming a photoconductive layer for electrophotography.

Usually, reactive sputtering is performed by the use of equipment as shown in Figure 6. Referring to the figure, numeral 31 designates a bell jar, numeral 32 an evacuating system, numeral 33 a radio-frequency power source, numeral 34 a sputtering target, numeral 35 a substrate holder, and numeral 36 a substrate. Sputtering equipment includes not only a structure which serves to perform sputter-evaporation on the flat substrate as exemplified in the figure, but also a structure which can perform sputter-evaporation on a cylindrical or drum-shaped substrate. The process may be chosen according to intended use of the device.

Reactive sputtering is carried out by evacuating the bell jar 31, introducing hydrogen and an inert gas such as argon thereinto, and supplying a radio-frequency voltage from the radio-frequency power source 33 to cause a discharge. The quantity of hydrogen which is contained in the layer formed at this time is determined principally by the pressure of hydrogen existing in the atmosphere gas during the discharge. The amorphous silicon layer containing hydrogen suited to this invention is produced when the hydrogen pressure during the sputtering lies in a range of from $5 \times 10^{-5}$ Torr (about $6.7 \times 10^{-3}$ Pa) to $9 \times 10^{-3}$ Torr (about 1.2 Pa).

The localized state density in the pure amorphous silicon containing no hydrogen is presumed to be of the order of $10^{20}/cm^3$. Supposing that hydrogen atoms extinguish the localized states at 1:1 when doping such amorphous silicon with hydrogen, all the localized states ought to be extinguished with a hydrogen-doping quantity of approximately 0.1 atomic-%. However, it is only when the hydrogen content exceeds approximately 1 atomic-% that amorphous silicon useful as a photoconductor is actually obtained owing to the appearance of the photoconductivity and to the occurrence of the variation of the optical forbidden band gap. Hydrogen can be contained up to approximately 50 atomic-%, but a content of at most 40 atomic-% is common and especially a content of at most 30 atomic-% is practical.

A material in which part of silicon is substituted by germanium, carbon or the like can also be used for the electrophotographic member. Useful as the quantity of the substitution by germanium or carbon is within 30 atomic-%.

In order to vary the hydrogen content of the amorphous silicon layer, there may be controlled the substrate temperature, the concentration of hydrogen in the atmosphere, the input power, etc. when forming the layer by any of the layer forming methods already described.

Among the layer forming methods mentioned above, one which has excellent controllability and which can readily produce a photoconductive amorphous silicon layer of high resistivity and good quality is the reactive sputtering process.

By doping the amorphous silicon layer with an impurity, it can be given a conductivity type such as p-type and n-type.

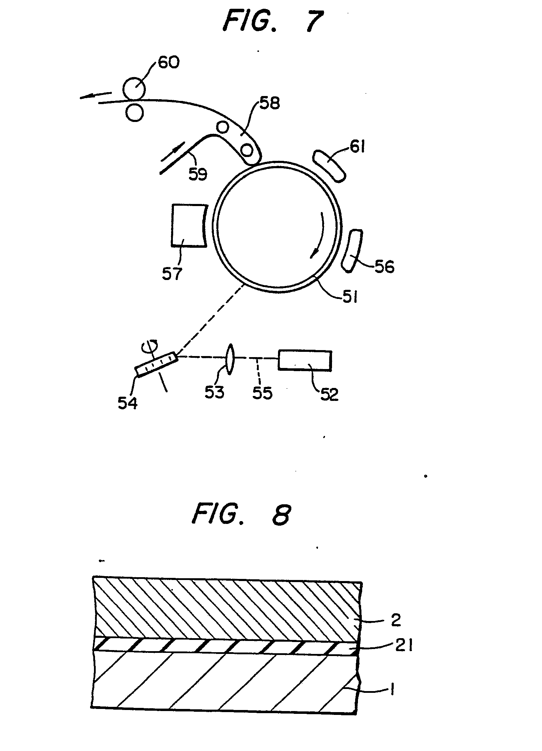

Referring to Figure 7, the electrophotographic plate according to the present invention is formed on the surface of a rotary drum 51. When the rotary drum 51 is formed of a conductor such as aluminum, the rotary drum 51 per se may be used as the conductor substrate of the electrophotographic member according to the present invention. When a rotary drum formed of glass or the like is used, a conductor such as a metal is coated on the surface of the rotary drum of glass, and a plurality of predetermined amorphous Si layers are laminated thereon. Beams 55 from a light source 52 such as a semiconductor laser pass through a beam collecting lens 53 and impinge on a polyhedral mirror 54, and they are reflected from the mirror 54 and reach the surface of the drum 51.

Charges induced on the drum 51 by a charger 56 are neutralized by signals imparted to the laser beams to form a latent image. The latent image region arrives at a toner station 57 where a toner adheres only to the latent image area irradiated with the laser beams. This toner is transferred onto a recording paper 59 in a transfer station 58. The transferred image is thermally fixed by a fixing heater 60. Reference numeral 61 represents a cleaner for the drum 51.

There may be adopted an embodiment in which a glass cylinder is used as the drum, a transparent conductive layer is formed on the glass cylinder and predetermined Si layers are laminated thereon.

In this embodiment, the writing light source may be disposed in the cylindrical drum. In this case, beams are incident from the conductor side of the electrophotographic plate.

Needless to say, the application of the electrophotographic member is not limited to the above-mentioned embodiments.

In the present specification and its appended claims, by the term "electrophotographic member" is meant one that is used for an electrophotographic device, a laser beam printer equipment and the like in the fields of electrophotography, printing, recording and the like.

Hereunder, this invention will be illustrated by Examples.

Example 1

Figure 8 is a sectional view of the electrophotographic member of this example.

An aluminum cylinder whose surface was mirror-polished was heated at 300°C in an oxygen atmosphere for 2 hours, to form an $Al_2O_3$ film 21 on the surface of the cylinder 1. The cylinder was installed in a rotary magnetron type sputtering equipment, the interior of which was evacuated up to $1 \times 10^{-6}$ Torr (about 1.3 to $10^{-4}$ Pa). Thereafter, whilst holding the cylinder at 200°C, an amorphous silicon film 2 having an optical forbidden band gap of 1.95 eV and a resistivity of $10^{11}\Omega$. cm was deposited theeon to a thickness of 20 μm at a deposition rate of 0.2 nm by a radio-frequency output of 350 W in a mixed atmosphere consisting of $2 \times 10^{-3}$ Torr (about 0.27 Pa) of hydrogen and $3 \times 10^{-3}$ Torr (about 0.4 Pa) of argon. The cylinder thus prepared was used to fabricate an electrophotographic device of a system in which the amorphous silicon film was illuminated by a He-Ne laser beam (wavelength: 630 nm) or by a white lamp through a filter adapted to cut light of and below 500 nm by an amount of at least 90%.

With such a construction, especially the residual potential can be sharply lowered.

More specifically, in an electrophotographic member having an amorphous-silicon photoconductive layer which contains at least 50 atomic-% of silicon and at least 1 atomic-% of hydrogen on the average within the layer, the distance between a portion in which light illuminating the photoconductive layer (light contributive to create photo-carriers within the photoconductor) is absorbed within the photoconductor until its intensity becomes 1% of that at incidence and the interface of the photoconductive layer opposite to the light incidence side thereof is at most 5 μm.

Table 2 lists examples in which amorphous silicon containing 12 atomic-% of hydrogen to form an electrophotographic member was set at various thicknesses, and the residual potentials of the samples were measured. Illuminating light was of wavelength 575 nm.

TABLE 2

| No. | Remaining light intensity (%) | Distance to opposite interface ($\mu$m) | Residual potential/Initial potential (%) | Thickness of layer ($\mu$m) | |
|---|---|---|---|---|---|
| 1 | 1 | 3 | 5 | 13 | |
| 2 | 1 | 5 | 5 | 15 | |
| 3 | 1 | 10 | 38 | 20 | comp. ex. |
| 4 | 1 | 15 | 40 | 25 | comp. ex. |

Table 3 indicates the relations between the residual potential and the value of the remaining light intensity at a position of 5 $\mu$m from the interface of a photoconductive layer opposite to the light incidence side thereof as represented by the percentage with respect to incident light ((remaining light intensity/ incident light intensity) $\times$ 100). As in the foregoing examples, the photoconductive layers were of amorphous silicon containing 12 atomic-% of hydrogen.

TABLE 3

| No. | Remaining light intensity (%) | Distance to opposite interface ($\mu$m) | Residual potential/Initial potential (%) | Thickness of layer ($\mu$m) | |
|---|---|---|---|---|---|
| 1 | 0.5 | 5 | 3 | 13 | |
| 2 | 1 | 5 | 5 | 15 | |
| 3 | 5 | 5 | 30 | 16 | comp. ex. |
| 4 | 10 | 5 | 40 | 18 | comp. ex. |

From the results of Tables 2 and 3, it is understood that the residual potential can be sharply lowered by making the intensity of the incident light on the photoconductive layer at most 1% of the intensity at the incidence in the portion 5 $\mu$m distant from the interface of the photoconductive layer opposite to the light incidence side thereof.

Example 2

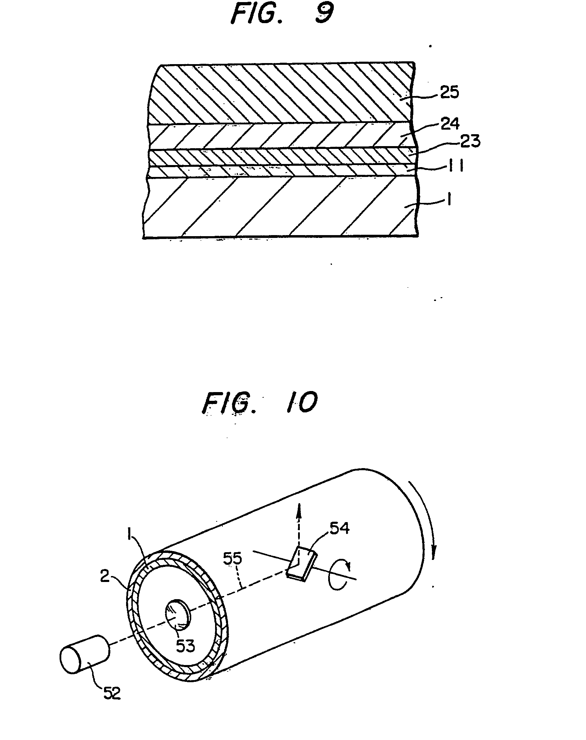

This example will be described with reference to Figure 9.

On a hard glass cylinder 1, a transparent electrode of $SnO_2$ 11 was formed by the thermodecomposition of $SnCl_4$ at 450°C. The resultant cylinder was installed in a rotary sputtering equipment, the interior of which was evacuated up to $2 \times 10^{-6}$ Torr (about $2.7 \times 10^{-4}$ Pa). Subsequently, whilst holding the cylinder at 250°C, an amorphous silicon film (hydrogen content: 17.5 atomic-%) 23 having an optical forbidden band gap of 1.95 eV and a resistivity of $10^{11}\Omega$.cm was deposited to a thickness of 18 $\mu$m at a deposition rate of 0.1 nm/sec by a radio-frequency power of 300 W (at a frequency of 13.56 MHz) in a mixed atmosphere consisting of $2 \times 10^{-3}$ Torr (about 0.27 Pa) of hydrogen and $2 \times 10^{-3}$ Torr (about 0.27 Pa) of argon. Thereafter, whilst holding the pressure of argon constant, the pressure of hydrogen was gradually lowered down to $3 \times 10^{-5}$ Torr (about $4 \times 10^{-3}$ Pa) over a period of time of 20 minutes. The amorphous silicon at the minimum hydrogen pressure (hydrogen content: 9 atomic-%) had an optical forbidden band gap of 1.6 eV and a resistivity of $10^8 \Omega$.cm. Further, the hydrogen pressure was gradually raised up to $2 \times 10^{-3}$ Torr (about 0.27 Pa) again over 20 minutes. Under these conditions the sputtering was continued to form amorphous silicon layers 24 and 25 to give a total thickness of 20 μm. A blocking layer of $As_2Se_3$ or the like may well be inserted on the transparent electrode 11. A blocking layer as stated before may be disposed on the photoconductive layer 25. The thickness of the region whose optical forbidden band gap was less than 1.95 eV was approximately 250 nm and the distance thereof from the underlying substrate was 1.7 μm. The cylinder was used as an electrophotographic drum.

In this construction also in which a region of narrow forbidden band gap is included in the photoconductive layer, this invention is effective for reducing the residual potential.

The electrophotographic member above described has its sensitivity and residual potential characteristics measured with a semiconductor laser having an emission wavelength of 760 nm. The results are indicated in Table 4.

TABLE 4

| Sample | Sensitivity (1/erg) | Residual potential/Initial potential (%) |
|---|---|---|
| This example | 0.07 | 5 |
| The region of narrow band gap is located in the middle of the layer | 0.07 | 15 |
| The region of narrow band gap is not formed | < 0.001 | > 80 |

As shown in Figure 10, the laser beam was projected onto the photoconductive layer from inside the drum. In the figure, numeral 1 designates a glass substrate, and numeral 2 a photoconductive layer. The details of the construction of the electrophotographic member, such as the electrode etc., are omitted from the illustration. Numeral 52 indicates a semiconductor laser, numeral 53 a beam collecting lens, numeral 54 a mirror and numeral 55 a laser beam. From the results of Table 4, it is understood that the present invention has extraordinarily good sensitivity and especially good residual potential characteristics.

Example 3

This example is a case where amorphous silicon doped with carbon is used at the surface and interface of a conductive layer. The fundamental structure is as shown in Figure 9.

On a polyimide film 1 a chrome film 11 was vacuum-evaporated to a thickness of 40 nm, to prepare a substrate. The resultant layer was installed in a sputtering equipment, the interior of which was evacuated up to $5 \times 10^{-7}$ Torr (about $6.7 \times 10^{-5}$ Pa). Thereafter, whilst holding the substrate at 150°C and by employing a target of polycrystalline silicon containing 10% of carbon, a film of amorphous silicon — carbon 23 having an optical forbidden band gap of 2.0 eV and a resistivity of $10^{13} \Omega$.cm was formed to 3 μm thickness at a deposition rate of 0.3 nm/sec under a radio-frequency power of 350 W in a gaseous mixture consisting of $1 \times 10^{-3}$ Torr (about 0.13 Pa) of hydrogen and $4 \times 10^{-3}$ Torr (about 0.53 Pa) of argon. The hydrogen content of this film was approximately 14 atomic-%. Thereafter, sputtering was performed by the use of a target made up of silicon only and in a gaseous mixture consisting of $2 \times 10^{-3}$ Torr (about 0.27 Pa) of argon and $2 \times 10^{-3}$ Torr (about 0.27 Pa) of hydrogen, to form a film of amorphous silicon 24 having a thickness of 60 nm and exhibiting an optical forbidden band gap of 1.85 eV as well as a resistivity of $10^{11} \Omega$.cm. Further, on the film 23, a film 25 of the first amorphous silicon — carbon was formed to a thickness of 5 μm.

An electrophotographic member having a satisfactory resolution and good residual potential characteristics with rspect to incident light at 650 nm could be realized.

Example 4

Reference is had to Figure 5.

On a hard glass cylinder 1, an $SnO_2$ transparent electrode 11 was formed by the thermodecomposition of $SnCl_4$ at 450°C. The resultant cylinder was installed in a rotary sputtering equipment, the interior of which was evacuated up to approximately $2 \times 10^{-6}$ Torr ($2.7 \times 10^{-4}$ Pa). Subsequently, whilst holding the cylinder at 250°C, an amorphous silicon film (hydrogen content: 17.5 atomic-%) 22 was deposited 2 nm by a radio-frequency power of 13.56 MHz and 300 W in a mixed atmosphere consisting of $2 \times 10^{-3}$ Torr (about 0.27 Pa) of hydrogen and $2 \times 10^{-3}$ Torr (about 0.27 Pa) of argon. The optical forbidden band gap of this film was 1.95 eV, and the resistivity was $10^{11}\Omega.cm$. Thereafter, using a sputtering target in which silicon and germanium were juxtaposed, a germanium-containing amorphous silicon film 23 was deposited to a thickness of 0.1 μm. The sputtering was a gaseous mixture consisting of $1 \times 10^{-3}$ Torr (about 0.13 Pa) hydrogen and $2 \times 10^{-3}$ Torr (about 0.27 Pa) of argon. The content of germanium was 30 atomic-%, and that of hydrogen was 10 atomic-%. In addition, the optical forbidden band gap was approximately 1.40 eV, and the resistivity was approximately $10^9\Omega.cm$. Subsequently, an amorphous silicon film 24 was formed to a thickness of 3 μm under the same conditions as the first amorphous silicon film. The optical forbidden band gap of the film 24 was 1.95 eV, and the resistivity was $10^{11}\Omega.cm$. When the germanium-containing amorphous silicon was used in this manner, an electrophotographic member having a satisfactory resolution and good residual potential characteristics with respect to illuminating light of 850 nm projected from inside the cylinder could be realized.

**Claims**

1. An electrophotographic member having a support (1) and a photoconductive layer (2) of amorphous silicon containing hydrogen and on average at least 50 atomic % silicon, the support carrying the layer, characterized in that the photoconductive layer (2) includes a first surface region (25) which is at least 10 nm thick and extends inwardly from a first surface of the photoconductive layer (2), the first surface region having an optical forbidden band gap of at least 1.6 eV and a resistivity of at least $10^{10}\Omega.cm$, and in that the thickness of said photoconductive layer (2) is such that the intensity of light of wavelength $\lambda_2$ (nm) illuminating the photoconductive layer (2) on its light incident side is reduced by absorption to 1% of the intensity of incidence at a distance of not more than 5 μm from the surface of the photoconductive layer (2) opposed to its light incident side, which surface is contacting an electrically conducting layer, $\lambda_2$ being given by

$$\lambda_2 \leq \lambda_1 - 100 \text{ nm}$$

wherein

$$\lambda_1 = \frac{1240}{E_{opt}}$$

in which $E_{opt}$ is the optical forbidden band gap (eV) of the layer (2).

2. An electrophotographic member according to claim 1 wherein within said amorphous silicon layer (2) beyond the said first surface region (25) thereof and at a depth of at least 10 nm from said first surface is an inner region (24) of amorphous silicon (containing hydrogen and on average at least 50 atomic % silicon) whose optical forbidden band gap is smaller than that of the said first surface region (25).

3. An electrophotographic member according to claim 2, wherein there is a second surface region (23) of said amorphous silicon layer (2) opposite to said first surface thereof, made of amorphous silicon (containing hydrogen and at least 50 atomic % silicon), which has an optical forbidden band gap which is at least 1.6 eV and is greater than that of the said inner region (24), and a resistivity of at least $10^{10}\Omega.cm$.

4. An electrophotographic member according to claim 2 or claim 3 wherein the face of said inner regions (24) closer to said surface of the layer (2) opposite said light incident side is at most 5 μm distant from said surface opposite said light incident side.

5. An electrophotographic member according to any one of claims 1 to 4 wherein said amorphous silicon layer (2) is formed by reactive sputtering in an atmosphere containing hydrogen.

6. An electrophotographic member according to any one of claims 1 to 5 wherein said amorphous silicon layer (2) contains at least one of germanium and carbon.

7. An electrophotographic system including at least one electrophotographic member according to any one of the preceding claims and a light source adapted to illuminate the light incident side of the electrophotographic member.

8. A method of operating an electrophotographic member having a support (1), and a photoconductive layer (2) of amorphous silicon containing hydrogen and at least 50 atomic % silicon carried by said support the photoconductive layer (2) including a surface region (25) which is at least 10 nm thick and extends inwardly from a surface of the photoconductive layer (2), the surface region having an optical forbidden band gap of at least 1.6 eV and a resistivity of at least $10^{10}\Omega.cm$, characterized in that the incident light is selected so that the distance between (a) the region at which the intensity of light illuminating said photoconductive layer (2) on the light incident side thereof is reduced by absorption therein to 1% of the intensity at incidence and (b) the surface of said photoconductive layer opposite to said light incidence side thereof is not more than 5 μm.

# 0 039 223

**Patentansprüche**

1. Elektrophotografisches Element mit einem Träger (1) und einer photoleitfähigen Schicht (2) aus amorphem Silizium, das Wasserstoff und durchschnittlich mindestens 50 Atom-% Silizium enthält, wobei der Träger die Schicht trägt, dadurch gekennzeichnet, daß die photoleitfähige Schicht (2) einen ersten Oberflächenbereich (25) aufweist, der mindestens 10 nm dick ist und sich von einer ersten Oberfläche der photoleitfähigen Schicht (2) einwärts erstreckt, wobei der erste Oberflächenbereich einen optischen Bandabstand von mindestens 1,6 eV und einen spezifischen Widerstand von mindestens $10^{10}$ $\Omega\cdot$cm aufweist, und daß die photoleitfähige Schicht (2) so dick ist, daß die Intensität von die photoleitfähige Schicht (2) auf dessen Lichteinfallsseite beleuchtenden Licht einer Wellenlänge $\lambda_2$ (nm) in einem Abstand von nicht mehr als 5 µm von der der Lichteinfallsseite gegenüberliegenden, mit einer elektrisch leitfähigen Schicht in Berührung stehenden Oberfläche der photoleitfähigen Schicht (2) durch Absorption auf 1% der Einfallsintensität reduziert wird, wobei $\lambda_2$ gegeben ist durch

$$\lambda_2 \leq \lambda_1 - 100 \text{ nm,}$$

mit

$$\lambda_1 = \frac{1240}{E_{opt}},$$

wobei $E_{opt}$ der optische Bandabstand (eV) der Schicht (2) ist.

2. Elektrophotografisches Element nach Anspruch 1, wobei innerhalb der amorphen Siliziumschicht (2) jenseits ihres ersten Oberflächenbereichs (25) und in einer Tiefe vom mindestens 10 nm von der ersten Oberfläche ein innerer Bereich (24) aus amorphem Silizium (das Wasserstoff und durchschnittlich mindestens 50 Atom-% Silizium enthält) vorhanden ist, dessen optischer Bandabstand kleiner ist als der des ersten Oberflächenbereichs (25).

3. Elektrophotografisches Element nach Anspruch 2, wobei ein von der ersten Oberfläche abgewandter zweiter Oberflächenbereich (23) der amorphen Siliziumschicht (2) vorhanden ist, der aus amorphem Silizium (das Wasserstoff und mindestens 50 Atom-% Silizium enthält) besteht, einen optischen Bandabstand aufweist, der mindestens 1,6 eV beträgt und größer ist als der des inneren Bereichs (24), und einen spezifischen Widerstand von mindestens $10^{10}$ $\Omega\cdot$cm hat.

4. Elektrophotografisches Element nach Anspruch 2 oder 3, wobei diejenige Fläche des inneren Bereichs (24), die sich näher an der von der Lichteinfallsseite abgewandten Oberfläche der Schicht (2) befindet, einen Abstand von höchstens 5 µm von der besagten, von der Lichteinfallsseite abgewandten Oberfläche hat.

5. Elektrophotografisches Element nach einem der Ansprüche 1 bis 4, wobei die amorphe Siliziumschicht (2) durch Reaktivzerstäubung in einer wasserstoffhaltigen Atmosphäre gebildet ist.

6. Elektrophotografisches Element nach einem der Ansprüche 1 bis 5, wobei die amorphe Siliziumschicht (2) Germanium und/oder Kohlenstoff enthält.

7. Elektrophotografisches System mit mindestens einem elektrophotografischen Element nach einem der vorhergehenden Ansprüche und einer Lichtquelle zur Beleuchtung der Lichteinfallsseite des elektrophotografischen Elements.

8. Verfahren zum Betrieb eines elektrophotografischen Elements, das einen Träger (1) und eine von diesem getragene photoleitfähige Schicht (2) aus amorphem Silizium aufweist, das Wasserstoff und mindestens 50 Atom-% Silizium enthält, wobei die photoleitfähige Schicht (2) einen Oberflächenbereich (25) aufweist, der mindestens 10 nm dick ist, sich von einer Oberfläche der photoleitfähigen Schicht (2) einwärts erstreckt und einen optischen Bandabstand von mindestens 1,6 eV sowie einen spezifischen Widerstand von mindestens $10^{10}$ $\Omega\cdot$cm hat, dadurch gekennzeichnet, daß das einfallende Licht so gewählt ist, daß der Abstand zwischen (a) dem Bereich, in dem die Intensität des die photoleitfähige Schicht (2) auf deren Lichteinfallsseite beleuchtenden Lichts durch Absorption auf 1% der Einfallsintensität reduziert wird, und (b) der von der Lichteinfallsseite abgewandten Oberfläche der photoleitfähigen Schicht nicht mehr als 5 µm beträgt.

**Revendications**

1. Elément électrophotographique comportant un support (1) et une couche photoconductrice (2) constituée par du silicium amorphe contenant de l'hydrogène et en moyenne au moins 50% d'atomes de silicium, le support portant la couche, caractérisé en ce que la couche photoconductrice (2) comporte une première région superficielle (25), qui possède une épaisseur au moins une épaisseur de 10 nm et s'étend vers l'intérieur à partir d'une première surface de la couche photoconductrice (2), la première région superficielle possédant une bande interdite optique d'au moins 1,6 eV et une résistivité égale à au moins $10^{10}$ $\Omega\cdot$cm, et que l'épaisseur de ladite couche photoconductrice (2) est telle que l'intensité de la lumière de longueur d'onde $\lambda_2$ (nm) éclairant la couche photoconductrice (2) sur sa face d'incidence de la lumière est

11

réduite, par absorption, à 1% de l'intensité incidente à une distance non supérieure à 5 µm de la surface de la couche photoconductrice (2) située à l'opposé de sa face d'incidence de la lumière, laquelle surface contacte une couche électriquement conductrice, $\lambda_2$ étant fournie par

$$\lambda_2 \leq \lambda_1 - 100 \text{ nm},$$

dans laquelle

$$\lambda_1 = \frac{1240}{E_{opt}},$$

dans laquelle $E_{opt}$ est la bande interdite optique (eV) de la couche (2).

2. Elément électrophotographique selon la revendication 1, dans lequel à l'intérieur de ladite couche de silicium amorphe (2) et au-dessous de ladite première région superficielle (25) de cette couche et à une profondeur d'au moins 10 nm à partir de ladite première surface se trouve disposée une région intérieure (24) constituée par du silicium amorphe (contenant de l'hydrogène et en moyenne au moins 50% d'atomes de silicium) et dont la bande interdite optique est inférieure à celle de ladite première région superficielle (25).

3. Elément électrophotographique selon la revendication 2, dans lequel il exite une second région superficielle (23) de ladite couche de silicium amorphe (2), située à l'opposé de ladite première surface de cette dernière et constituée par du silicium amorphe (contenant de l'hydrogène et au moins 50% d'atomes de silicium) qui possède une bande interdite optique qui est égale à au moins 1,6 eV et qui est supérieure à celle de ladite région intérieure (24), et une résistivité égale à au moins $10^{10}$ Ω·cm.

4. Elément électrophotographique selon la revendication 2 ou 3, dans lequel la phase desdites régions intérieures (24) qui est plus proche de ladite surface de la couche (2) située à l'oppose de ladite phase d'incidence de la lumière, est située à une distance d'au moins 5 µm de ladite surface située à l'opposé de ladite phase d'incidence de la lumière.

5. Elément électrophotographique selon l'une quelconque des revendications 1 à 4, dans lequel ladite couche de silicium amorphe (2) est formée par pulvérisation réactive dans une atmosphère contenant de l'hydrogène.

6. Elément électrophotographique selon l'une quelconque des revendications 1 à 5, dans lequel ladite couche de silicium amorphe (2) contient au moins un des éléments que sont le germanium et le carbone.

7. Système électrophotographique incluant au moins un élément électrophotographique selon l'une quelconque des revendications précédentes et une source de lumière apte à éclairer la face d'incidence de la lumière de l'élément électrophotographique.

8. Procédé de mise en oeuvre d'un élément électrophotographique comportant un support (1) et une couche photoconductrice (2) de silicium amorphe contenant de l'hydrogène et au moins 50% d'atomes de silicium, portée par ledit support, ladite couche photoconductrice (2) incluant une région superficielle (25) qui possède une épaisseur d'au moins 10 nm et s'étend vers l'intérieur à partir d'une surface de la couche photoconductrice (2), la région superficielle possédant une bande interdite optique égale à au moins 1,6 eV et une résistivité égale à au moins $10^{10}$ Ω·cm, caractérisé en ce que: la lumière incidente est choisie de manière que la distance entre (a) la région dans laquelle l'intensité de la lumière éclairant ladite couche photoconductrice (2) sur sa face d'incidence de la lumière est réduite par absorption en elle-même, à 1% de l'intensité incidente et (b) la surface de ladite couche photoconductrice, qui est située à l'opposé de la face d'incidence de la lumière de cette couche, n'est pas supérieure à 5 µm.

12

## FIG. 1

## FIG. 2

## FIG. 3

Eopt

ENERGY

STATE DENSITY

## FIG. 4

## FIG. 5

## FIG. 6

## FIG. 7

## FIG. 8

## FIG. 9

## FIG. 10